# EUROPÄISCHE PATENTSCHRIFT

(11) **EP 3 804 136 B1**
(45) Veröffentlichungstag und Bekanntmachung des Hinweises auf die Patenterteilung: **15.11.2023**
(21) Anmeldenummer: 19766181.2
(22) Anmeldetag: 20.08.2019
(51) Int. Cl.: H03K 17/0812, H03K 17/0412, H03K 17/04

(54) **BETREIBEN EINES BIPOLARTRANSISTORS MIT ISOLIERTER GATE-ELEKTRODE**
DRIVING OF A BIPOLAR TRANSISTOR HAVING INSULATED GATE ELECTRODE
PILOTAGE D'UN TRANSISTOR BIPOLAIRE À ÉLECTRODE À GRILLE ISOLÉE

(30) Priorität: 28.08.2018 EP 18191128
(43) Veröffentlichungstag der Anmeldung: 14.04.2021
(73) Patentinhaber: Siemens Aktiengesellschaft, 80333 München (DE)
(72) Erfinder: ECKEL, Hans-Günter, 18059 Rostock (DE); FUHRMANN, Jan, 18057 Rostock (DE); KAYSER, Felix, 18055 Rostock (DE); TRAN, Quang Tien, 18106 Rostock (DE)
(74) Vertreter: Siemens Patent Attorneys
(86) Internationale Anmeldenummer: PCT/EP2019/072200
(87) Internationale Veröffentlichungsnummer: WO 2020/043540

(56) Entgegenhaltungen:
- DE-B3-102013 223 135
- JP-A- 2002 153 043

## Beschreibung

Die Erfindung betrifft ein Verfahren und einen Gate-Treiber zum Betreiben eines Bipolartransistors mit isolierter Gate-Elektrode (IGBT, englisch: insulated-gate bipolar transistor) .

Bei dem Ausschalten eines IGBT treten in dem IGBT hohe elektrische Feldstärken auf, die zu dynamischem Avalanche führen können. Dies kann zum spontanen Ausfall oder zu einer langfristigen Degeneration des IGBT führen. Besonders ausgeprägt ist dieses Problem bei hohen Sperrspannungen im Bereich von 3,3 kV und darüber. Im bekannten Stand der Technik wird das Problem beispielsweise dadurch gelöst, dass die Schaltgeschwindigkeit des IGBT reduziert wird. Die Reduktion der Schaltgeschwindigkeit reduziert die Feldstärkebelastung des IGBT und kann daher dynamischen Avalanche verhindern. Allerdings vergrößert eine Reduktion der Schaltgeschwindigkeit die Ausschaltverluste beim Ausschalten des IGBT.

DE 10 2013 223 135 B3 offenbart eine Schaltungsanordnung und ein Verfahren zum Ansteuern eines IGBT mit einem Treibersignal zum Laden oder Entladen des Gate des IGBT und einem Triggersignal. Das Triggersignal signalisiert einen ersten Zeitpunkt, der während eines Ausschaltvorganges des IGBT zeitlich im Bereich des Anstiegs der Kollektor-Emitterspannung des IGBT liegt. Mit dem Treibersignal wird zu oder nach dem ersten Zeitpunkt das Gate für einen definierten Zeitraum wieder aufgeladen, um transiente Avalanche-Oszillationen zu vermeiden.

JP 2002 153043 A offenbart eine Stromrichteranordnung mit einem Leistungshalbleiterschalter, bei dem in einem Strombereich mit Transistoren auf einen Gatewiderstand für die Verlängerung der Ausschaltbetriebszeit umgeschaltet wird, um ein transientes Avalanchephänomen zu unterdrücken.

Der Erfindung liegt die Aufgabe zugrunde, dynamischen Avalanche beim Ausschalten eines IGBT zu verhindern, ohne dabei die Schaltgeschwindigkeit des IGBT im Normalbetrieb zu reduzieren.

Die Aufgabe wird erfindungsgemäß durch ein Verfahren mit den Merkmalen des Anspruchs 1 und einen Gate-Treiber mit den Merkmalen des Anspruchs 6 gelöst.

Vorteilhafte Ausgestaltungen der Erfindung sind Gegenstand der abhängigen Ansprüche.

Bei dem erfindungsgemäßen Verfahren zum Betreiben eines IGBT werden zunächst eine für einen Betrieb des IGBT erforderliche maximale stationäre Sperrspannung, eine erste Entnahmeladung, deren Entnahme am Gate des IGBT eine elektrische Feldstärke bewirkt, die es ermöglicht, dass der IGBT beim stationären Sperren die maximale stationäre Sperrspannung aufnehmen kann, und eine zweite Entnahmeladung, deren Entnahme am Gate eine elektrische Feldstärke bewirkt, die zu einem dynamischen Avalanche führt, bestimmt. Dem Gate wird beim Ausschalten des IGBT während einer Ladungsentnahmedauer eine Entnahmeladung entnommen, die größer als die erste Entnahmeladung und kleiner als die zweite Entnahmeladung ist. Im Folgenden wird die erste Entnahmeladung daher auch als minimale Entnahmeladung bezeichnet und die zweite Entnahmeladung wird auch als maximale Entnahmeladung bezeichnet. Die erste Entnahmeladung und die zweite Entnahmeladung werden beispielsweise anhand von bekannten Eigenschaften des IGBT, die beispielsweise wenigstens teilweise einem Datenblatt des IGBT entnommen werden, und/oder experimentell durch Versuche bestimmt und vorgegeben.

Die Erfindung sieht also vor, beim Ausschalten des IGBT eine Ladungsmenge zu steuern, die dem Gate des IGBT entnommen wird, um dynamischen Avalanche zu verhindern. Die Erfindung nutzt aus, dass die beim Ausschalten in dem IGBT auftretenden elektrischen Feldstärken von der Ladung abhängen, die dem Gate des IGBT beim Ausschalten entnommen wird. Die der Erfindung zugrunde liegende Idee ist, die dem Gate beim Ausschalten entnommene Ladungsmenge zu begrenzen, um dynamischen Avalanche zu verhindern. Dazu werden eine minimale Entnahmeladung, deren Entnahme am Gate die Aufnahme einer maximalen stationären Sperrspannung durch den IGBT ermöglicht, und eine maximale Entnahmeladung, deren Entnahme am Gate zu einem dynamischen Avalanche führt, bestimmt und dem Gate wird beim Ausschalten des IGBT eine Entnahmeladung entnommen, die zwischen der minimalen und der maximalen Entnahmeladung liegt. Dadurch wird beim Ausschalten des IGBT dynamischer Avalanche verhindert, ohne die Schaltgeschwindigkeit des IGBT im Nennbetrieb reduzieren zu müssen und dadurch die Ausschaltverluste beim Ausschalten des IGBT im Nennbetrieb zu erhöhen.

Die Entnahmeladung wird durch Anlegen einer Ausschaltspannung zwischen dem Gate und dem Emitter während der Ladungsentnahmedauer entnommen. Ferner wird während des Anlegens der Ausschaltspannung ein in dem Gate fließender Gatestrom gemessen, aus dem Gatestrom wird eine dem Gate entnommene Ladung ermittelt und ein Ende der Ladungsentnahmedauer wird dadurch definiert, dass die dem Gate entnommene Ladung die Entnahmeladung erreicht. Die Erfindung sieht also vor, die dem Gate beim Ausschalten des IGBT entnommene Ladung durch das Anlegen einer Gate-Emitter-Spannung während der Ladungsentnahmedauer zu steuern. Das Messen der dem Gate entnommenen Ladung ermöglicht die Begrenzung dieser Ladung auf die Entnahmeladung insbesondere auch dann, wenn der Gatestrom in dem Gate während der Ladungsentnahmedauer nicht konstant ist.

Bei einer Ausgestaltung der Erfindung wird die Entnahmeladung durch Erzeugen eines während der Ladungsentnahmedauer in dem Gate fließenden konstanten Gatestroms entnommen. Diese Ausgestaltung der Erfindung ermöglicht die Definition der Ladungsentnahmedauer als den Quotienten der Entnahmeladung und des konstanten Gatestroms. Wenn der Gatestrom bekannt ist, wird dazu keine Messung des Gatestroms benötigt.

Bei einer weiteren Ausgestaltung der Erfindung wird ein Schwellenwert für die Gate-Emitter-Spannung des IGBT vorgegeben und die Entnahme von Ladung aus dem Gate wird abgebrochen, wenn die Gate-Emitter-Spannung den Schwellenwert erreicht. Diese Ausgestaltung der Erfindung verhindert, dass die Gate-Emitter-Spannung beim Ausschalten des IGBT zu niedrig wird und zu einer Beschädigung des IGBT führt.

Bei dem erfindungsgemäßen Verfahren zum Betreiben zweier zu einer Halbbrücke verschalteter IGBT wird jeder IGBT mit dem oben beschriebenen erfindungsgemäßen Verfahren oder einer seiner Ausgestaltungen betrieben. Die beiden IGBT werden abwechselnd für jeweils eine Einschaltdauer eingeschaltet, wobei je zwei aufeinander folgende Einschaltdauern durch eine Verriegelungsdauer, in der beide IGBT ausgeschaltet sind, voneinander getrennt sind. Die Ladungsentnahmedauer für jeden IGBT wird in zwei durch eine Entnahmepause voneinander getrennte Ladungsentnahmedauerteile aufgeteilt, wobei ein erster Ladungsentnahmedauerteil mit dem Ausschalten des IGBT beginnt und vor dem Einschalten des anderen IGBT endet und der zweite Ladungsentnahmedauerteil nach dem Ende des ersten Ladungsentnahmedauerteils und vor dem Einschalten des anderen IGBT beginnt und mit dem Einschalten des IGBT endet.

Das vorgenannte Verfahren berücksichtigt, dass es je nach dem Verhältnis zwischen der Millerkapazität und der Gate-Emitter-Kapazität in einem IGBT und der negativen treibenden Spannung der Ansteuerschaltung bei Anwendung des erfindungsgemäßen Verfahrens bei dem Ausschalten des IGBT dazu kommen kann, dass die Gate-Emitter-Spannung bereits die negative treibende Spannung erreicht hat, bevor die vorgesehene Entnahmeladung dem Gate entnommen werden konnte. Beim Einschalten des anderen IGBT nimmt der ausgeschaltete IGBT dann Spannung auf. Durch die Millerkapazität kann es daraufhin zu einem parasitären Einschalten des hochohmig angesteuerten, ausgeschalteten IGBT kommen. Bei dem vorgenannten Verfahren wird dies dadurch vermieden, dass die Ladungsentnahme aus dem Gate unterbrochen wird und nach der Unterbrechung vor dem Ablauf der Verriegelungszeit, aber nach dem Ablauf eines regulären Ausschaltvorgangs wieder aufgenommen wird und das Gate auf diese Weise auf niedrigem Potential unterhalb der Thresholdspannung des IGBT gehalten wird.

Bei den vorgenannten erfindungsgemäßen Verfahren und deren Ausgestaltungen beträgt die Ladungsentnahmedauer beispielsweise zwischen einhundert Nanosekunden und zehn Mikrosekunden. Eine derartige Ladungsentnahmedauer ermöglicht in der Regel das Entnehmen einer Ladung aus dem Gate eines IGBT, die zwischen der minimalen und der maximalen Entnahmeladung liegt.

Ein erfindungsgemäßer Gate-Treiber für einen IGBT zur Durchführung des erfindungsgemäßen Verfahrens ist dazu ausgebildet, den IGBT abwechselnd für eine Einschaltdauer einzuschalten und für eine Ausschaltdauer auszuschalten und dem Gate des IGBT in jeder Ausschaltdauer die Entnahmeladung zu entnehmen.

Der Gate-Treiber umfasst einen ansteuerbaren Ausschalthalbleiterschalter, der zum Anlegen einer Ausschaltspannung zwischen dem Gate und dem Emitter des IGBT einschaltbar ist, einen zwischen den Ausschalthalbleiterschalter und das Gate geschalteten oder der Gate-Emitter-Strecke des IGBT nachgeschalteten Ausschaltwiderstand und eine Ansteuerlogik, die dazu ausgebildet ist, den Ausschalthalbleiterschalter für die Ladungsentnahmedauer einzuschalten. Der Gate-Treiber umfasst ferner eine Strommessvorrichtung zum Messen eines in dem Gate fließenden Gatestroms, wobei die Ansteuerlogik dazu ausgebildet ist, aus dem Gatestrom eine dem Gate entnommene Ladung zu ermitteln und ein Ende der Ladungsentnahmedauer dadurch zu definieren, dass die dem Gate entnommene Ladung die Entnahmeladung erreicht. Zusätzlich kann der Gate-Treiber eine zu dem Ausschalthalbleiterschalter und dem Ausschaltwiderstand parallel geschaltete Reihenschaltung eines Zusatzausschalthalbleiterschalters und eines Zusatzausschaltwiderstands aufweisen, wobei der Zusatzausschaltwiderstand größer als der Ausschaltwiderstand ist und der Zusatzausschalthalbleiterschalter zum Anlegen einer Zusatzausschaltspannung zwischen dem Gate und dem Emitter einschaltbar ist.

Ein erfindungsgemäßer Gate-Treiber ermöglicht die Ladungsentnahme aus dem Gate eines IGBT mittels eines Ausschalthalbleiterschalters und Ausschaltwiderstands sowie einer Ansteuerlogik zum Ansteuern des Ausschalthalbleiterschalters, um den Ausschalthalbleiterschalter für die Ladungsentnahme aus dem Gate einzuschalten und zum Beenden der Ladungsentnahme auszuschalten. Eine den Gatestrom messende Strommessvorrichtung ermöglicht die Bestimmung der dem Gate entnommenen Ladung durch Integration des Gatestroms über die Zeit und damit die Begrenzung der Ladungsentnahme auf die vorgesehene Entnahmeladung durch ein Beenden der Ladungsentnahme beim Erreichen der Entnahmeladung. Durch eine parallel zu dem Ausschalthalbleiterschalter und dem Ausschaltwiderstand geschaltete Reihenschaltung eines Zusatzausschalthalbleiterschalters und eines Zusatzausschaltwiderstands, der größer als der Ausschaltwiderstand ist, kann das Ausschaltverhalten des IGBT vorteilhaft stabilisiert werden, indem der Zusatzausschalthalbleiterschalter während der Ausschaltdauer des IGBT eingeschaltet wird. Durch die Wahl eines ausreichend großen Zusatzausschaltwiderstands kann dabei erreicht werden, dass dem Gate des IGBT durch das Einschalten des Zusatzausschalthalbleiterschalters nur wenig zusätzliche Ladung entnommen wird, so dass dem Gate die Entnahmeladung überwiegend durch das Einschalten des Ausschalthalbleiterschalters entnommen wird.

Eine Ausgestaltung des erfindungsgemäßen Gate-Treibers sieht eine ansteuerbare Ausschaltstromquelle, die zum Erzeugen eines konstanten Gatestroms in dem Gate einschaltbar ist, und eine Ansteuerlogik, die dazu ausgebildet ist, die Ausschaltstromquelle für die Ladungsentnahmedauer einzuschalten, vor. Diese Ausgestaltung des erfindungsgemäßen Gate-Treibers ermöglicht eine Definition der Ladungsentnahmedauer durch den Quotienten aus der Entnahmeladung und dem konstanten Gatestrom, so dass bei einem bekannten konstanten Gatestrom insbesondere keine Strommessvorrichtung zum Messen des Gatestroms erforderlich ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: einen Schaltplan eines IGBT und eines ersten Ausführungsbeispiels eines Gate-Treibers für einen IGBT,
- FIG 2: zeitliche Verläufe von Schaltzuständen des IGBT und des Gate-Treibers, die in Figur 1 gezeigt sind,
- FIG 3: einen Schaltplan eines IGBT und eines zweiten Ausführungsbeispiels eines Gate-Treibers für einen IGBT,
- FIG 4: zeitliche Verläufe von Schaltzuständen des IGBT und des Gate-Treibers, die in FIG 3 gezeigt sind,
- FIG 5: einen Schaltplan eines IGBT und eines dritten Ausführungsbeispiels eines Gate-Treibers für einen IGBT,
- FIG 6: einen Schaltplan einer Halbbrückenschaltung mit zwei IGBT und einem Gate-Treiber für jeden IGBT,
- FIG 7: zeitliche Verläufe von Schaltzuständen der IGBT und Gate-Treiber, die in FIG 6 gezeigt sind.

Einander entsprechende Teile sind in den Figuren mit denselben Bezugszeichen versehen.

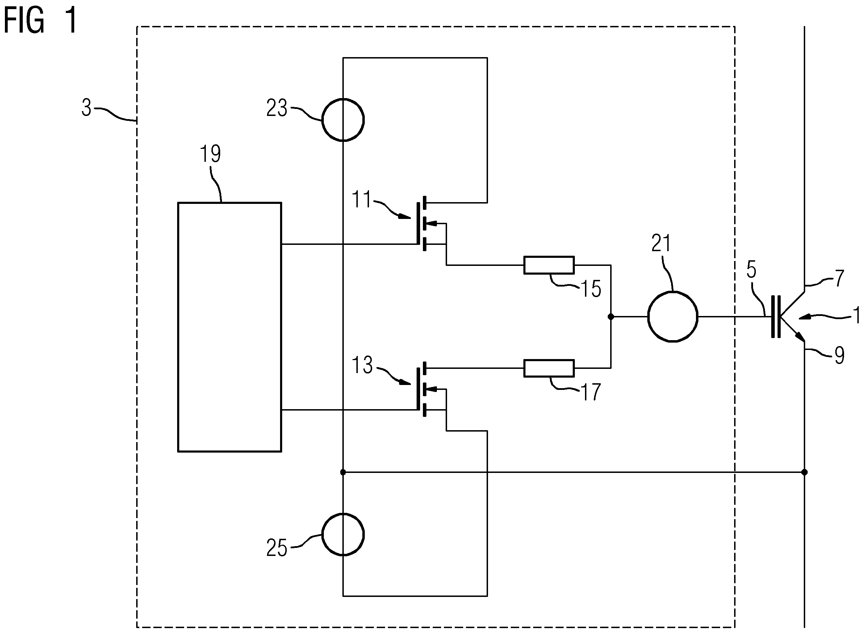

FIG 1 zeigt einen Schaltplan eines IGBT 1 und eines ersten Ausführungsbeispiels eines Gate-Treibers 3 für einen IGBT 1.

Der IGBT 1 weist ein Gate 5, einen Kollektor 7 und einen Emitter 9 auf.

Der Gate-Treiber 3 weist einen Einschalthalbleiterschalter 11, einen Ausschalthalbleiterschalter 13, einen Einschaltwiderstand 15, einen Ausschaltwiderstand 17, eine Ansteuerlogik 19, eine optionale Strommessvorrichtung 21, eine Einschaltspannungsquelle 23 und eine Ausschaltspannungsquelle 25 auf.

Der Einschalthalbleiterschalter 11 ist über den Einschaltwiderstand 15 mit dem Gate 5 des IGBT 1 verbunden. Der Ausschalthalbleiterschalter 13 ist über den Ausschaltwiderstand 17 mit dem Gate 5 des IGBT 1 verbunden. Der Einschalthalbleiterschalter 11 und der Ausschalthalbleiterschalter 13 sind von der Ansteuerlogik 19 ansteuerbar. Der Einschalthalbleiterschalter 11, der Einschaltwiderstand 15, der Ausschalthalbleiterschalter 13 und der Ausschaltwiderstand 17 sind zu einer Halbbrücke mit einem Brückenzweig, der mit dem Gate 5 des IGBT 1 verbunden ist, einem ersten Brückenarm, in dem der Einschalthalbleiterschalter 11 und der Einschaltwiderstand 15 angeordnet sind, und einem zweiten Brückenarm, in dem der Ausschalthalbleiterschalter 13 und der Ausschaltwiderstand 17 angeordnet sind, verschaltet. Die Strommessvorrichtung 21 ist in dem Brückenzweig der Halbbrücke angeordnet.

Die Einschaltspannungsquelle 23 erzeugt eine Einschaltversorgungsspannung für den Einschalthalbleiterschalter 11. Die Ausschaltspannungsquelle 25 erzeugt eine Ausschaltversorgungsspannung für den Ausschalthalbleiterschalter 13.

In dem in FIG 1 dargestellten Ausführungsbeispiel sind der Einschalthalbleiterschalter 11 und der Ausschalthalbleiterschalter 13 jeweils als ein Metall-Oxid-Halbleiter-Feldeffekttransistor (MOSFET, englisch: metal-oxide-semiconductor field-effect transistor), genauer als ein normal sperrender n-Kanal-MOSFET, ausgebildet, dessen Gate-Anschluss mit der Ansteuerlogik 19 verbunden ist. Der Source-Anschluss des Einschalthalbleiterschalters 11 ist mit dem Einschaltwiderstand 15 verbunden. Der Drain-Anschluss des Ausschalthalbleiterschalters 13 ist mit dem Ausschaltwiderstand 17 verbunden. Ein erster Pol der Einschaltspannungsquelle 23 ist mit dem Drain-Anschluss des Einschalthalbleiterschalters 11 verbunden. Ein erster Pol der Ausschaltspannungsquelle 25 ist mit dem Source-Anschluss des Ausschalthalbleiterschalters 13 verbunden. Der zweite Pol der Einschaltspannungsquelle 23 und der zweite Pol der Ausschaltspannungsquelle 25 sind miteinander und mit dem Emitter 9 des IGBT 1 verbunden. Die zweiten Pole der Einschaltspannungsquelle 23 und der Ausschaltspannungsquelle 25 liegen daher auf einem gemeinsamen ersten elektrischen Potential. Der erste Pol der Einschaltspannungsquelle 23 liegt auf einem zweiten elektrischen Potential, das höher als das erste elektrische Potential ist. Der erste Pol der Ausschaltspannungsquelle 25 liegt auf einem dritten elektrischen Potential, das niedriger als das erste elektrische Potential ist. Die Einschaltversorgungsspannung ist daher positiv, die Ausschaltversorgungsspannung ist negativ.

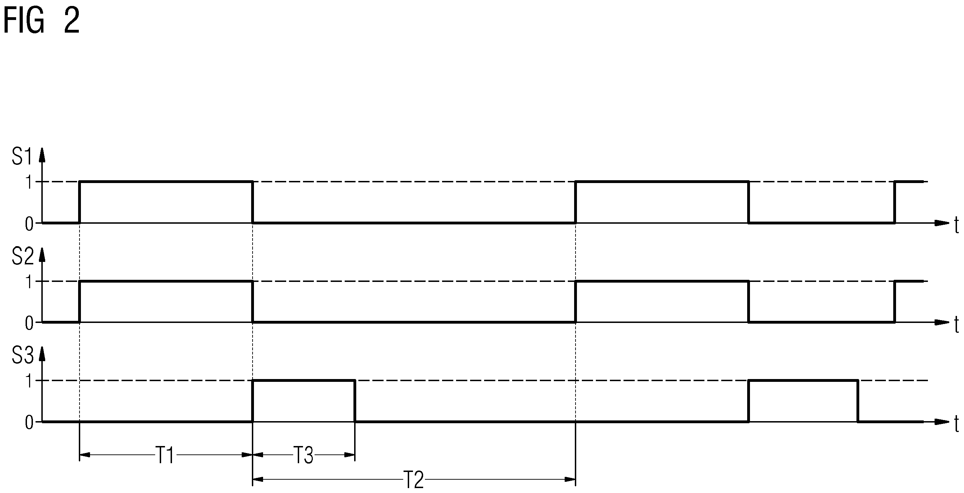

FIG 2 illustriert das erfindungsgemäße Verfahren zum Betreiben eines IGBT 1 mit einem in FIG 1 gezeigten Gate-Treiber 3 anhand von Verläufen eines Schaltzustands S1 des IGBT 1, eines Schaltzustands S2 des Einschalthalbleiterschalters 11 und eines Schaltzustands S3 des Ausschalthalbleiterschalters 13 in Abhängigkeit von einer Zeit t. Jeder Schaltzustand S1, S2, S3 nimmt abwechselnd den Wert Eins, der einen Einschaltzustand bezeichnet, und den Wert Null, der einen Ausschaltzustand bezeichnet, an.

Bei dem Verfahren werden zunächst eine für einen Betrieb des IGBT 1 erforderliche maximale stationäre Sperrspannung, eine minimale Entnahmeladung, deren Entnahme am Gate 5 des IGBT 1 eine elektrische Feldstärke bewirkt, die es ermöglicht, dass der IGBT 1 beim stationären Sperren die maximale stationäre Sperrspannung aufnehmen kann, und eine maximale Entnahmeladung, deren Entnahme am Gate 5 eine elektrische Feldstärke bewirkt, die zu einem dynamischen Avalanche führt, bestimmt.

Der IGBT 1 wird abwechselnd für eine Einschaltdauer T1 eingeschaltet und für eine Ausschaltdauer T2 ausgeschaltet. Während jeder Einschaltdauer T1 wird der Einschalthalbleiterschalter 11 eingeschaltet und der Ausschalthalbleiterschalter 13 wird ausgeschaltet. Während jeder Ausschaltdauer T2 wird der Einschalthalbleiterschalter 11 ausgeschaltet und der Ausschalthalbleiterschalter 13 wird zunächst für eine Ladungsentnahmedauer T3 eingeschaltet und nach dem Ablauf der Ladungsentnahmedauer T3 ausgeschaltet. Die Ladungsentnahmedauer T3 wird dadurch definiert, dass dem Gate 5 des IGBT 1 während der Ladungsentnahmedauer T3 eine vorher bestimmte Entnahmeladung, die größer als die minimale Entnahmeladung und kleiner als die maximale Entnahmeladung ist, entnommen wird, das heißt der Ausschalthalbleiterschalter 13 wird ausgeschaltet, sobald die dem Gate 5 entnommene Ladung die Entnahmeladung erreicht. Dazu wird beispielsweise mit der Strommessvorrichtung 21 laufend ein in dem Gate fließender Gatestrom erfasst und mittels der Ansteuerlogik 19 aus dem erfassten Gatestrom die dem Gate entnommene Ladung ermittelt, indem der Gatestrom nach dem Einschalten des Ausschalthalbleiterschalters 13 über die Zeit integriert wird. Alternativ wird mit dem Ausschalthalbleiterschalter 13 zwischen dem Gate 5 und dem Emitter 9 über den Ausschaltwiderstand 17 eine Ausschaltspannung erzeugt, die einen konstanten Gatestrom erzeugt, und die Ladungsentnahmedauer T3 durch den Quotienten aus der Entnahmeladung und dem konstanten Gatestrom definiert.

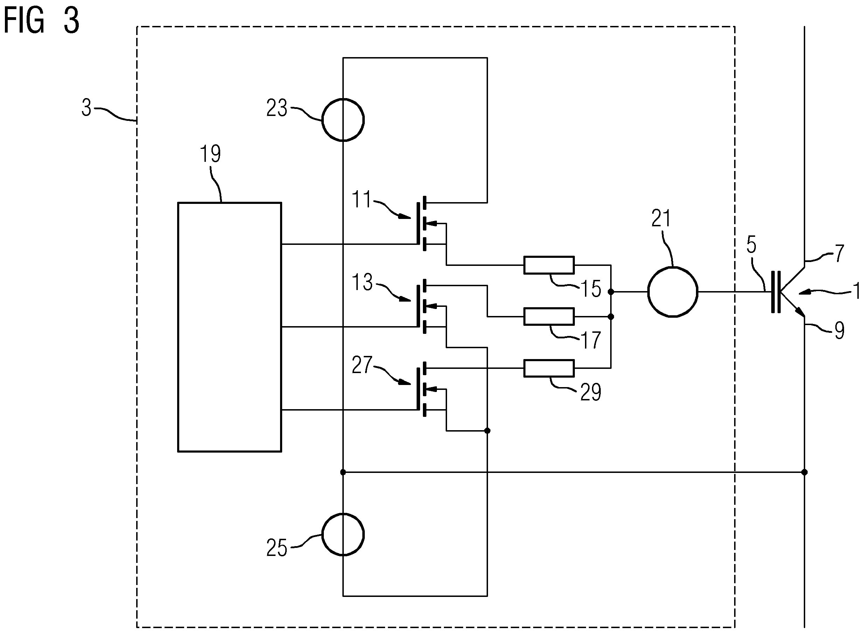

FIG 3 zeigt einen Schaltplan eines IGBT 1 und eines zweiten Ausführungsbeispiels eines Gate-Treibers 3 für einen IGBT 1. Der Gate-Treiber 3 unterscheidet sich von dem in FIG 1 dargestellten Ausführungsbeispiel lediglich durch eine zu dem Ausschalthalbleiterschalter 13 und dem Ausschaltwiderstand 17 parallel geschaltete Reihenschaltung eines Zusatzausschalthalbleiterschalters 27 und eines Zusatzausschaltwiderstands 29. Dabei ist der Zusatzausschaltwiderstand 29 größer als der Ausschaltwiderstand 17. Der Zusatzausschalthalbleiterschalter 27 ist als ein normal sperrender n-Kanal-MOSFET ausgebildet. Der Gate-Anschluss des Zusatzausschalthalbleiterschalters 27 ist mit der Ansteuerlogik 19 verbunden, so dass der Zusatzausschalthalbleiterschalter 27 durch die Ansteuerlogik 19 ansteuerbar ist. Der Drain-Anschluss des Zusatzausschalthalbleiterschalters 27 ist über den Zusatzausschaltwiderstand 29 mit dem Gate 5 des IGBT 1 verbunden. Der Source-Anschluss des Zusatzausschalthalbleiterschalters 27 ist mit dem ersten Pol der Ausschaltspannungsquelle 25 verbunden.

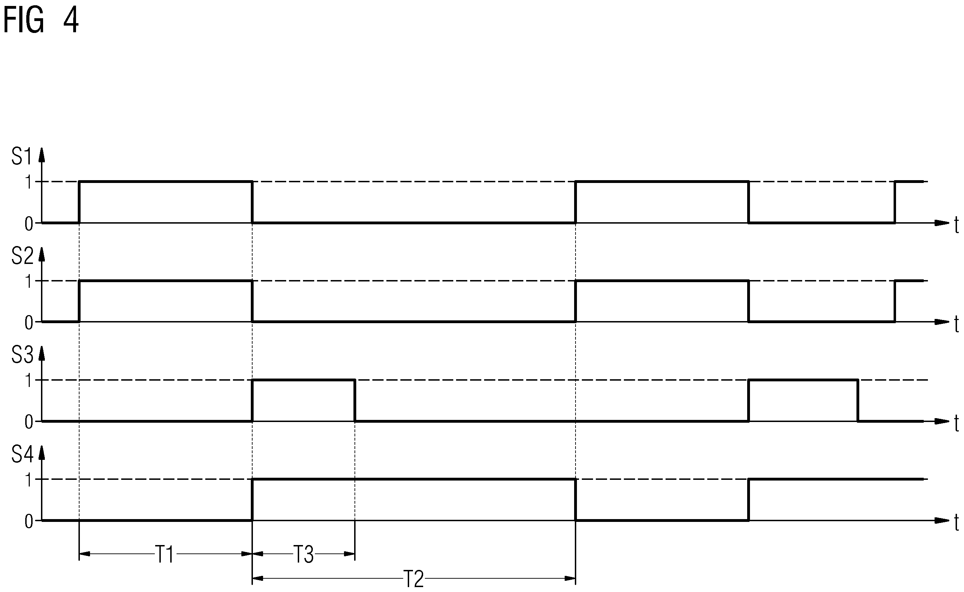

FIG 4 illustriert das erfindungsgemäße Verfahren zum Betreiben eines IGBT 1 mit einem in Figur 3 gezeigten Gate-Treiber 3 anhand von zeitlichen Verläufen eines Schaltzustands S1 des IGBT 1, eines Schaltzustands S2 des Einschalthalbleiterschalters 11, eines Schaltzustands S3 des Ausschalthalbleiterschalters 13 und eines Schaltzustands S4 des Zusatzausschalthalbleiterschalters 27.

Wiederum werden eine für einen Betrieb des IGBT 1 erforderliche maximale stationäre Sperrspannung, eine minimale Entnahmeladung, deren Entnahme am Gate 5 des IGBT 1 eine elektrische Feldstärke bewirkt, die es ermöglicht, dass der IGBT 1 beim stationären Sperren die maximale stationäre Sperrspannung aufnehmen kann, und eine maximale Entnahmeladung, deren Entnahme am Gate 5 eine elektrische Feldstärke bewirkt, die zu einem dynamischen Avalanche führt, bestimmt.

Der IGBT 1 wird abwechselnd für eine Einschaltdauer T1 eingeschaltet und für eine Ausschaltdauer T2 ausgeschaltet. Während jeder Einschaltdauer T1 wird der Einschalthalbleiterschalter 11 eingeschaltet und der Ausschalthalbleiterschalter 13 und der Zusatzausschalthalbleiterschalter 27 werden ausgeschaltet. Während jeder Ausschaltdauer T2 wird der Einschalthalbleiterschalter 11 ausgeschaltet, der Ausschalthalbleiterschalter 13 wird zunächst für eine Ladungsentnahmedauer T3 eingeschaltet und nach dem Ablauf der Ladungsentnahmedauer T3 ausgeschaltet und der Zusatzausschalthalbleiterschalter 27 wird eingeschaltet. Die Ladungsentnahmedauer T3 wird dadurch definiert, dass dem Gate 5 des IGBT 1 während einer Ausschaltdauer T2 eine Entnahmeladung, die größer als die minimale Entnahmeladung und kleiner als die maximale Entnahmeladung ist, entnommen wird. Im Unterschied zu dem anhand von Figur 2 beschriebenen Ausführungsbeispiel des erfindungsgemäßen Verfahrens wird dem Gate 5 in diesem Fall durch das Einschalten des Zusatzausschalthalbleiterschalters 27 während der gesamten Ausschaltdauer T2 Ladung entnommen. Bei ausreichend großem Zusatzausschaltwiderstand 29 ist die dem Gate 5 nach dem Ausschalten des Ausschalthalbleiterschalters 13 während der Ausschaltdauer T2 entnommene Ladung jedoch klein, so dass sie entweder ganz vernachlässigt werden kann, oder es wird der Ermittlung der Ladungsentnahmedauer T3 eine um diese Ladung reduzierte maximale Entnahmeladung zugrunde gelegt. Durch das Einschalten des Zusatzausschalthalbleiterschalters 27 während einer Ausschaltdauer T2 kann das Ausschaltverhalten des IGBT 1 vorteilhaft stabilisiert werden.

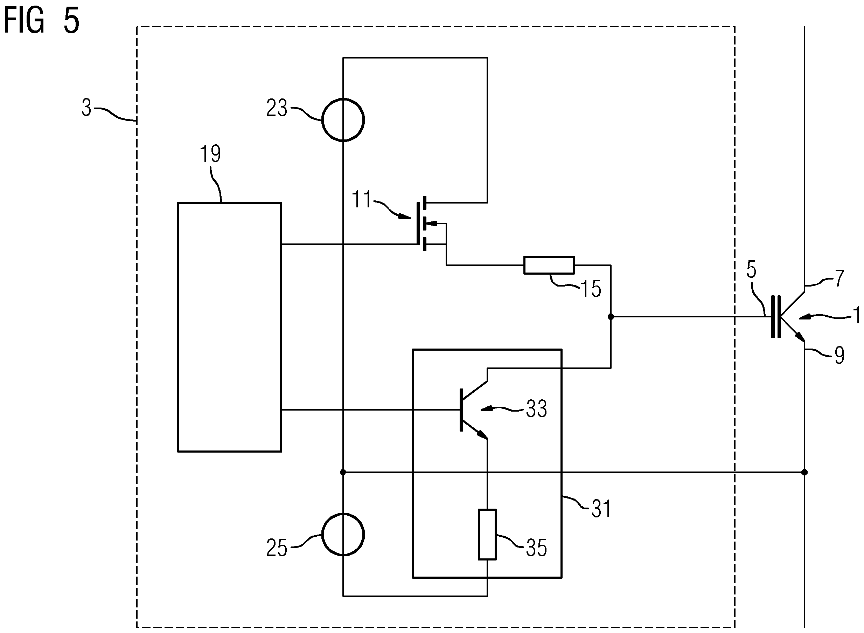

FIG 5 zeigt einen Schaltplan eines IGBT 1 und eines dritten Ausführungsbeispiels eines Gate-Treibers 3 für einen IGBT 1. Der Gate-Treiber 3 unterscheidet sich von dem in FIG 1 dargestellten Ausführungsbeispiel dadurch, dass er anstelle der Reihenschaltung des Ausschalthalbleiterschalters 13 und des Ausschaltwiderstands 17 eine Ausschaltstromquelle 31 zum Erzeugen eines konstanten Gatestroms aufweist. Die Ausschaltstromquelle 31 wird analog zu dem Ausschalthalbleiterschalter 13 in dem anhand von Figur 2 beschriebenen Ausführungsbeispiel des erfindungsgemäßen Verfahrens während jeder Ausschaltdauer T2 des IGBT 1 für eine Ladungsentnahmedauer T3 eingeschaltet. Die Ladungsentnahmedauer T3 wird durch den Quotienten aus der Entnahmeladung und dem konstanten Gatestrom definiert. Während der Einschaltdauer T1 des IGBT 1, in der der Einschalthalbleiterschalter 11 eingeschaltet ist, und der restlichen Ausschaltdauer T2 wird die Ausschaltstromquelle 31 abgeschaltet. In dem in Figur 5 dargestellten Ausführungsbeispiel eines Gate-Treibers 3 ist die Ausschaltstromquelle 31 durch eine Reihenschaltung eines durch die Ansteuerlogik 19 ansteuerbaren Bipolartransistors 33 und eines Stromquellenwiderstands 35 realisiert. Andere Ausführungen einer durch die Ansteuerlogik 19 ansteuerbaren Ausschaltstromquelle 31 sind jedoch auch möglich.

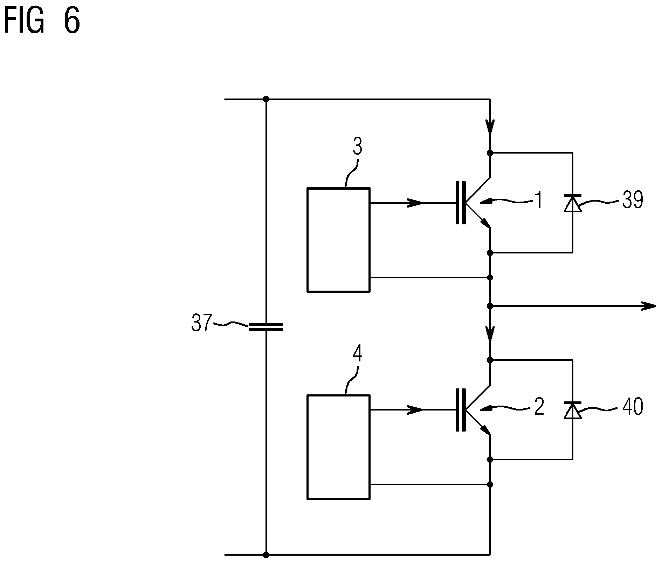

FIG 6 zeigt einen Schaltplan einer Halbbrückenschaltung mit zwei IGBT 1, 2, einem ersten Gate-Treiber 3 für einen ersten IGBT 1 und einem zweiten Gate-Treiber 4 für den zweiten IGBT 2. Jeder IGBT 1, 2 ist in einem Brückenarm einer Halbbrücke angeordnet. Die Brückenarme sind durch einen Kondensator 37 miteinander verbunden. Zu jedem IGBT 1, 2 ist eine Freilaufdiode 39, 40 parallel geschaltet. Jeder Gate-Treiber 3, 4 ist wie der Gate-Treiber 3 des in FIG 1 oder FIG 5 dargestellten Ausführungsbeispiels ausgebildet.

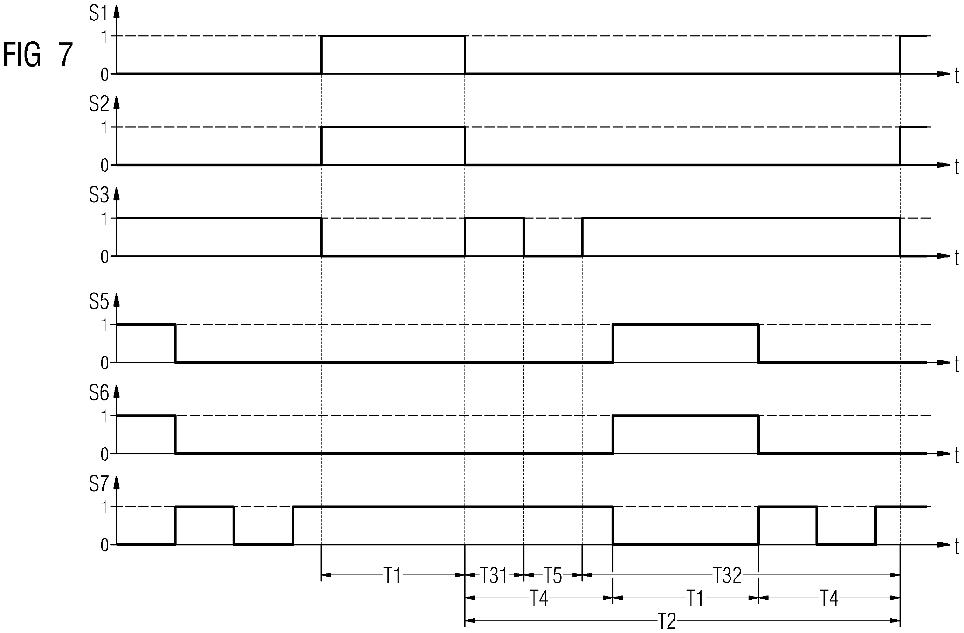

FIG 7 illustriert das erfindungsgemäße Verfahren zum Betreiben zweier gemäß FIG 6 zu einer Halbbrücke verschalteter IGBT 1, 2 anhand von zeitlichen Verläufen eines Schaltzustands S1 des ersten IGBT 1, eines Schaltzustands S2 des Einschalthalbleiterschalters 11 des ersten Gate-Treibers 3, eines Schaltzustands S3 des Ausschalthalbleiterschalters 13 des ersten Gate-Treibers 3, eines Schaltzustands S5 des zweiten IGBT 2, eines Schaltzustands S6 des Einschalthalbleiterschalters 11 des zweiten Gate-Treibers 4 und eines Schaltzustands S7 des Ausschalthalbleiterschalters 13 des zweiten Gate-Treibers 4.

Für jeden IGBT 1, 2 wird eine für dessen Betrieb erforderliche maximale stationäre Sperrspannung, eine minimale Entnahmeladung, deren Entnahme am Gate 5 des IGBT 1, 2 eine elektrische Feldstärke bewirkt, die es ermöglicht, dass der IGBT 1 beim stationären Sperren die maximale stationäre Sperrspannung aufnehmen kann, und eine maximale Entnahmeladung, deren Entnahme am Gate 5 eine elektrische Feldstärke bewirkt, die zu einem dynamischen Avalanche führt, bestimmt.

Die beiden IGBT 1, 2 werden abwechselnd für jeweils eine Einschaltdauer T1 eingeschaltet, wobei je zwei aufeinander folgende Einschaltdauern T1 durch eine Verriegelungsdauer T4 voneinander getrennt sind, in der beide IGBT 1, 2 ausgeschaltet sind.

Während jeder Ausschaltdauer T2 jedes IGBT 1, 2 wird dem Gate 5 des IGBT 1, 2 während einer Ladungsentnahmedauer T3 analog zu dem anhand von Figur 2 beschriebenen Verfahren eine Entnahmeladung entnommen, die größer als die für ihn bestimmte minimale Entnahmeladung und kleiner als die für ihn bestimmte maximale Entnahmeladung ist. Die Ladungsentnahmedauer T3 wird dabei jedoch in zwei durch eine Entnahmepause T5 voneinander getrennte Ladungsentnahmedauerteile T31, T32 aufgeteilt, wobei ein erster Ladungsentnahmedauerteil T31 mit dem Ausschalten des IGBT 1, 2 beginnt und vor dem Einschalten des anderen IGBT 2, 1 endet und der zweite Ladungsentnahmedauerteil T32 nach dem Ende des ersten Ladungsentnahmedauerteils T31 und vor dem Einschalten des anderen IGBT 2, 1 beginnt und mit dem Einschalten des IGBT 1, 2 endet.

Das anhand von FIG 7 beschriebene Verfahren kann analog zu dem anhand von FIG 4 beschriebenen Verfahren abgewandelt werden, wenn die Gate-Treiber 3, 4 jeweils wie der in FIG 3 dargestellte Gate-Treiber 3 ausgeführt sind.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Betreiben eines IGBT (1,2), wobei
- eine für einen Betrieb des IGBT (1,2) erforderliche maximale stationäre Sperrspannung bestimmt wird,
- eine erste Entnahmeladung anhand von bekannten Eigenschaften des IGBT (1,2), die beispielsweise wenigstens teilweise einem Datenblatt des IGBT (1,2) entnommen werden, und/oder experimentell durch Versuche bestimmt wird, deren Entnahme am Gate (5) des IGBT (1,2) eine erste elektrische Feldstärke bewirkt, die es ermöglicht, dass der IGBT (1,2) beim stationären Sperren die maximale stationäre Sperrspannung aufnehmen kann,
- eine zweite Entnahmeladung anhand von bekannten Eigenschaften des IGBT, die beispielsweise wenigstens teilweise einem Datenblatt des IGBT entnommen werden, und/oder experimentell durch Versuche bestimmt wird, deren Entnahme am Gate (5) eine zweite elektrische Feldstärke bewirkt, die zu einem dynamischen Avalanche führt, und
- dem Gate (5) beim Ausschalten des IGBT (1,2) während einer Ladungsentnahmedauer (T3) eine Entnahmeladung entnommen wird, die größer als die erste Entnahmeladung und kleiner als die zweite Entnahmeladung ist, wobei
- die Entnahmeladung durch Anlegen einer Ausschaltspannung zwischen dem Gate (5) und dem Emitter (9) des IGBT (1,2) während der Ladungsentnahmedauer (T3) entnommen wird,
**dadurch gekennzeichnet, dass** während des Anlegens der Ausschaltspannung ein in dem Gate (5) fließender Gatestrom gemessen wird, aus dem Gatestrom eine dem Gate (5) entnommene Ladung ermittelt wird und ein Ende der Ladungsentnahmedauer (T3) dadurch definiert wird, dass die dem Gate (5) entnommene Ladung die Entnahmeladung erreicht.

2. Verfahren nach Anspruch 1, wobei die Entnahmeladung durch Erzeugen eines während der Ladungsentnahmedauer (T3) in dem Gate (5) fließenden konstanten Gatestroms entnommen wird.

3. Verfahren nach einem der vorhergehenden Ansprüche, wobei ein Schwellenwert für die Gate-Emitter-Spannung des IGBT (1, 2) vorgegeben wird und die Entnahme von Ladung aus dem Gate (5) abgebrochen wird, wenn die Gate-Emitter-Spannung den Schwellenwert erreicht.

4. Verfahren zum Betreiben zweier zu einer Halbbrücke verschalteter IGBT (1,2), wobei
- jeder IGBT (1,2) mit einem Verfahren nach einem der vorhergehenden Ansprüche betrieben wird,
- die beiden IGBT (1,2) abwechselnd für jeweils eine Einschaltdauer (T1) eingeschaltet werden, wobei je zwei aufeinander folgende Einschaltdauern (T1) durch eine Verriegelungsdauer (T4) voneinander getrennt sind, und
- die Ladungsentnahmedauer (T3) für jeden IGBT (1,2) in zwei durch eine Entnahmepause (T5) voneinander getrennte Ladungsentnahmedauerteile (T31, T32) aufgeteilt wird, wobei ein erster Ladungsentnahmedauerteil (T31) mit dem Ausschalten des IGBT (1,2) beginnt und vor dem Einschalten des anderen IGBT (2,1) endet und der zweite Ladungsentnahmedauerteil (T32) nach dem Ende des ersten Ladungsentnahmedauerteils (T31) und vor dem Einschalten des anderen IGBT (2,1) beginnt und mit dem Einschalten des IGBT (1,2) endet.

5. Verfahren nach einem der vorhergehenden Ansprüche, wobei die Ladungsentnahmedauer (T3) zwischen einhundert Nanosekunden und zehn Mikrosekunden beträgt.

6. Gate-Treiber (3,4) für einen IGBT (1,2) zur Durchführung des Verfahrens nach einem der vorhergehenden Ansprüche, wobei der Gate-Treiber (3,4) dazu ausgebildet ist, den IGBT (1,2) abwechselnd für eine Einschaltdauer (T1) einzuschalten und für eine Ausschaltdauer (T2) auszuschalten und dem Gate (5) des IGBT (1,2) in jeder Ausschaltdauer (T2) die Entnahmeladung zu entnehmen, der Gate-Treiber (3,4) umfassend
- einen ansteuerbaren Ausschalthalbleiterschalter (13), der zum Anlegen einer Ausschaltspannung zwischen dem Gate (5) und dem Emitter (9) des IGBT (1,2) einschaltbar ist,
- einen zwischen den Ausschalthalbleiterschalter (13) und das Gate (5) geschalteten oder der Gate-Emitter-Strecke des IGBT (1,2) nachgeschalteten Ausschaltwiderstand (17),
- eine Ansteuerlogik (19), die dazu ausgebildet ist, den Ausschalthalbleiterschalter (13) für die Ladungsentnahmedauer (T3) einzuschalten, und
- eine Strommessvorrichtung (21) zum Messen eines in dem Gate (5) fließenden Gatestroms, wobei
- die Ansteuerlogik (19) dazu ausgebildet ist, aus dem Gatestrom eine dem Gate (5) entnommene Ladung zu ermitteln und ein Ende der Ladungsentnahmedauer (T3) dadurch zu definieren, dass die dem Gate (5) entnommene Ladung die Entnahmeladung erreicht.

7. Gate-Treiber (3,4) nach Anspruch 6 mit einer zu dem Ausschalthalbleiterschalter (13) und dem Ausschaltwiderstand (17) parallel geschalteten Reihenschaltung eines Zusatzausschalthalbleiterschalters (27) und eines Zusatzausschaltwiderstands (29), wobei der Zusatzausschaltwiderstand (29) größer als der Ausschaltwiderstand (17) ist und der Zusatzausschalthalbleiterschalter (27) zum Anlegen einer Zusatzausschaltspannung zwischen dem Gate (5) und dem Emitter (9) einschaltbar ist.

8. Gate-Treiber (3,4) nach Anspruch 6 oder 7 mit einer ansteuerbaren Ausschaltstromquelle (31), die zum Erzeugen eines konstanten Gatestroms in dem Gate (5) einschaltbar ist, wobei die Ansteuerlogik (19) dazu ausgebildet ist, die Ausschaltstromquelle (31) für die Ladungsentnahmedauer (T3) einzuschalten.

## Claims

1. Method for operating an IGBT (1,2), wherein
- a maximum steady-state reverse voltage required for operation of the IGBT (1,2) is determined,
- a first removal charge is determined on the basis of known properties of the IGBT (1, 2), which are taken, for example, at least partially from a data sheet of the IGBT (1, 2), and/or experimentally by means of tests, the removal of which at the gate (5) of the IGBT (1,2) brings about an electric field strength which enables the IGBT (1,2) to accept the maximum steady-state reverse voltage during steady-state blocking,
- a second removal charge is determined on the basis of known properties of the IGBT, which are taken, for example, at least partially from a data sheet of the IGBT, and/or experimentally by means of tests, the removal of which at the gate (5) brings about a second electric field strength which leads to a dynamic avalanche, and
- during switching off of the IGBT (1,2) a removal charge greater than the first removal charge and less than the second removal charge is removed from the gate (5) during a charge removal period (T3), wherein
- the removal charge is removed by applying a switch-off voltage between the gate (5) and the emitter (9) of the IGBT (1,2) during the charge removal period (T3)
**characterised in that**
- during the application of the switch-off voltage, a gate current flowing in the gate (5) is measured, a charge taken from the gate (5) is determined from the gate current and an end of the charge removal period (T3) is defined **in that** the charge taken from the gate (5) reaches the removal charge.

2. Method according to claim 1, wherein the removal charge is removed by generating a constant gate current flowing in the gate (5) during the charge removal period (T3).

3. Method according to one of the preceding claims, wherein a threshold value for the gate-emitter voltage of the IGBT (1, 2) is predetermined and the removal of charge from the gate (5) is terminated when the gate-emitter voltage reaches the threshold value.

4. Method for operating two IGBT (1,2) connected to form a half bridge, wherein
- each IGBT (1,2) is operated using a method according to one of the preceding claims,
- the two IGBT (1,2) are alternately switched on for a respective switch-on period (T1), wherein in each case two consecutive switch-on periods (T1) are separated from one another by a locking period (T4), and
- the charge removal period (T3) for each IGBT (1,2) is divided into two charge removal periods (T31, T32) separated from one another by a removal pause (T5), wherein a first charge removal period (T31) begins with the switching off of the IGBT (1,2) and ends before the other IGBT (2,1) is switched on and the second charge removal period (T32) begins after the end of the first charge removal period (T31) and before the other IGBT (2,1) is switched on and ends with the switching on of the IGBT (1,2).

5. Method according to one of the preceding claims, wherein the charge removal period (T3) is between one hundred nanoseconds and ten microseconds.

6. Gate driver (3,4) for an IGBT (1,2) for performing the method according to one of the preceding claims, wherein the gate driver (3,4) is designed to alternately switch on the IGBT (1,2) for a switch-on period (T1) and to switch off the IGBT (1,2) for a switch-off period (T2) and to remove the removal charge from the gate (5) of the IGBT (1,2) in each switch-off period (T2), the gate driver (3,4) comprising
- a controllable switch-off semiconductor switch (13) which can be switched on for applying a switch-off voltage between the gate (5) and the emitter (9) of the IGBT (1,2),
- a switch-off resistor (17) connected between the switch-off semiconductor switch (13) and the gate (5) or connected downstream of the gate emitter path of the IGBT (1,2),
- a control logic (19) which is designed to switch on the switch-off semiconductor switch (13) for the charge removal period (T3), and
- a current measuring apparatus (21) for measuring a gate current flowing in the gate (5), wherein
- the control logic (19) is designed to determine a charge taken from the gate (5) from the gate current and to define an end of the charge removal period (T3) in that the charge taken from the gate (5) reaches the removal charge.

7. Gate driver (3,4) according to claim 6 with a series circuit of an additional switch-off semiconductor switch (27) connected in parallel with the switch-off semiconductor switch (13) and the switch-off resistor (17) and an additional switch-off resistor (29), wherein the additional switch-off resistor (29) is greater than the switch-off resistor (17) and the additional switch-off semiconductor switch (27) can be switched on between the gate (5) and the emitter (9) in order to apply an additional switch-off voltage.

8. Gate driver (3,4) according to claim 6 or 7 with a controllable switch-off current source (31) which can be switched on in order to generate a constant gate current in the gate (5), wherein the control logic (19) is designed to switch on the switch-off current source (31) for the charge removal period (T3).

## Revendications

1. Procédé pour faire fonctionner un IGBT (1, 2), dans lequel
- on détermine une tension de blocage maximum en régime permanent nécessaire pour un fonctionnement de l'IGBT (1, 2),
- on détermine une première charge de prélèvement à l'aide de propriétés connues de l'IGBT (1, 2), qui ont été prélevées par exemple au moins en partie d'une feuille de données de l'IGBT (1,2) et/ou expérimentalement par des essais dont le prélèvement à la grille (5) de l'IGBT (1, 2) provoque une première intensité du champ électrique, qui permet que l'IGBT (1, 2) puisse, en blocage en régime permanent, accepter la tension de blocage maximum en régime permanent,
- on détermine une deuxième charge de prélèvement à l'aide de propriétés connues de l'IGBT, qui ont été prises par exemple au moins en partie dans une feuille de données de l'IGBT et/ou par des essais expérimentalement dont le prélèvement à la grille (5) provoque une deuxième intensité du champ électrique, qui conduit à une avalanche dynamique,
- on prélève à la grille (5) alors que l'IGBT (1, 2) est hors circuit, pendant une durée (T3) de prélèvement de charge, une charge de prélèvement, qui est plus grande que la première charge de prélèvement et plus petite que la deuxième charge de prélèvement, dans lequel
- on prélève la charge de prélèvement en appliquant une tension de blocage entre la grille (5) et l'émetteur (9) de l'IGBT (1, 2) pendant la durée (T3) de prélèvement de charge,
**caractérisé en ce que**
pendant l'application de la tension de blocage, on mesure un courant de grille passant dans la grille (5), on détermine à partir du courant de grille une charge prélevée à la grille (5) et on définit une fin de la durée (T3) de prélèvement de charge par le fait que la charge prélevée à la grille (5) atteint la charge de prélèvement.

2. Procédé suivant la revendication 1, dans lequel on prélève la charge de prélèvement par production d'un courant de grille constant passant dans la grille (5) pendant la durée (T3) de prélèvement de charge.

3. Procédé suivant l'une des revendications précédentes, dans lequel on prescrit une valeur de seuil pour la tension de grille-émetteur de l'IGBT (1, 2) et on interrompt le prélèvement de charge de la grille (5) si la tension de grille-émetteur atteint la valeur de seuil.

4. Procédé pour faire fonctionner deux IGBT (1, 2) montés en un demi-pont, dans lequel
- on fait fonctionner chaque IGBT (1, 2) par un procédé suivant l'une des revendications précédentes,
- on met les deux IGBT (1, 2) en alternance à l'état passant pendant respectivement une durée (T1) de mise à l'état passant, dans lequel respectivement deux durées (T1) de mise à l'état passif qui se succèdent sont séparées l'une de l'autre par une durée (T4) de verrouillage,
- on subdivise la durée (T3) de prélèvement de charge pour chaque IGBT (1, 2) en deux parties (T31, T32) de durée de prélèvement de charge séparées l'une de l'autre par une pause (T5) de prélèvement, dans lequel une première partie (T31) de durée de prélèvement de charge commence avec le blocage de l'IGBT (1, 2) et se termine avant la mise à l'état passant de l'autre IGBT (2, 1) et la deuxième partie (T32) de la durée de prélèvement de charge commence après la fin de la première partie (T31) de la durée de prélèvement de charge et avant la mise à l'état passant de l'autre IGBT (2, 1) et se termine avec la mise à l'état passant de l'IGBT (1, 2).

5. Procédé suivant l'une des revendications précédentes, dans lequel la durée (T3) de prélèvement de charge est comprise entre cent nanosecondes et dix microsecondes.

6. Circuit (3, 4) d'attaque de grille d'un IGBT (1, 2) pour effectuer le procédé suivant l'une des revendications précédentes, dans lequel le circuit (3, 4) d'attaque de grille est constitué pour mettre l'IGBT (1, 2) en alternance à l'état passant pendant une durée (T1) de mise à l'état passant et pour le bloquer pendant une durée (T2) de blocage et pour prélever de la grille (5) de l'IGBT (1, 2) dans chaque durée (T2) de blocage la charge de prélèvement, le circuit (3, 4) d'attaque de grille comprenant
- un interrupteur (13) à semi-conducteur de blocage pouvant être commandé, qui peut être fermé pour l'application d'une tension de blocage entre la grille (5) et l'émetteur (9) de l'IGBT (1, 2),
- une résistance (17) de blocage montée entre l'interrupteur (13) à semi-conducteur de blocage et la grille (5) ou montée en aval de la section grille-émetteur de l'IGBT (1, 2),
- une logique (19) de commande, qui est constituée pour fermer l'interrupteur (13) à semi-conducteur de blocage pendant la durée (T3) de prélèvement de charge, et
- un système (21) de mesure de courant pour la mesure d'un courant de grille passant dans la grille (5), dans lequel
- la logique (19) de commande est constituée pour déterminer à partir du courant de grille une charge prélevée à la grille (5) et pour définir une fin de la durée (T3) de prélèvement de charge par le fait que la charge prélevée à la grille (5) atteint la charge de prélèvement.

7. Circuit (3, 4) d'attaque de grille suivant la revendication 6, comprenant un circuit série, monté en parallèle à l'interrupteur (13) à semi-conducteur de blocage et à la résistance (17) de blocage, d'un interrupteur (27) à semi-conducteur de blocage supplémentaire et d'une résistance (29) de blocage supplémentaire, dans lequel la résistance (29) de blocage supplémentaire est plus grande que la résistance (17) de blocage et l'interrupteur (27) à semi-conducteur de blocage supplémentaire peut être fermé pour l'application d'une tension de blocage supplémentaire entre la grille (5) et l'émetteur (9).

8. Circuit (3, 4) d'attaque de grille suivant la revendication 6 ou 7, comprenant une source (31) de courant de blocage pouvant être commandée, qui peut être mise en circuit pour la production d'un courant de grille constant dans la grille (5), dans lequel la logique (19) de commande est constituée pour mettre la source (31) de courant de blocage en circuit pendant la durée (T3) de prélèvement de charge.
